# FASCICULE DE BREVET EUROPEEN

(11) **EP 0 391 812 B1**
(45) Date de publication et mention de la délivrance du brevet: **15.12.1993**
(21) Numéro de dépôt: 90420155.5
(22) Date de dépôt: 29.03.1990
(51) Int. Cl.: G01R 31/02

(54) **Système de controle d'isolement d'un réseau à courant continu**
Gleichstromnetz-Isolierungskontrollsystem
D.C. current network insulation monitoring system

(30) Priorité: 06.04.1989 FR 8904705
(43) Date de publication de la demande: 10.10.1990
(73) Titulaire: MERLIN GERIN, F-38240 Meylan (FR)
(72) Inventeur: Schuster, Philippe, F-38050 Grenoble Cédex (FR); Moussanet, Roland, F-38050 Grenoble Cédex (FR)
(74) Mandataire: Ritzenthaler, Jacques

(56) Documents cités:
- EP-A- 0 194 225
- FR-A- 2 398 312
- FR-A- 2 400 444
- US-A- 4 188 574
- PATENT ABSTRACTS OF JAPAN, vol. 7, no. 113 (P-197)[1258], 18 mai 1983; & JP-A-58 33 167 (HIOKI DENKI K.K.) 26-02-1983

## Description

L'invention est relative à un dispositif de contrôle d'isolement d'un réseau à courant continu en service et isolé de la terre, ayant un générateur de courant alternatif connecté entre la terre et le réseau pour injecter un courant alternatif dans le réseau sous une tension non dangereuse pour les personnes et un transformateur de courant ayant un tore de mesure portant un enroulement primaire constitué par le conducteur dudit réseau et un enroulement secondaire de mesure.

Les réseaux à courant continu sont utilisés fréquemment dans les stations de commande et d'alimentation de moteurs ou sur les bateaux, et ces installations ne tolèrent pas des défaillances de l'alimentation. Le réseau est isolé de la terre et un premier défaut à la terre n'entrave donc pas le bon fonctionnement de l'installation. Il est néanmoins impératif de détecter ce premier défaut, qui peut dégénérer ou engendrer un court-circuit lors de l'apparition d'un deuxième défaut à la terre. Le contrôle est de préférence permanent et en tous les cas ne doit pas impliquer la mise hors service du réseau. Un contrôle en différents points du réseau permet de plus une localisation rapide du défaut. Le premier défaut à la terre induit une circulation d'un courant alternatif à travers le réseau et la terre, mais l'intensité de ce courant, qui est fonction de la tension du générateur de courant alternatif et de la résistance du circuit de défaut, est pour des raisons de sécurité relativement faible, par exemple de 3 à 20 mA, par rapport à l'intensité du courant continu qui peut atteindre plusieurs centaines d'ampères. Dans ces conditions la détection de la composante alternative du courant dans le réseau ne peut être réalisée par les transformateurs de courant standard, dont le matériau magnétique du tore est saturé par le courant continu.

L'emploi d'un autre type de capteur, par exemple d'un capteur à effet Hall, qui ne risque pas d'être saturé, ne donne pas satisfaction, leur précision de mesure étant insuffisante.

La présente invention a pour but de permettre la réalisation d'un dispositif de contrôle d'isolement fiable et non dangereux pour les personnes.

Le dispositif de contrôle d'isolement selon l'invention est caractérisé en ce que ledit tore de mesure comporte de plus un enroulement de compensation alimenté par un générateur de courant continu de façon à engendrer dans le tore de mesure un champ magnétique antagoniste au champ engendré par le courant continu et que ledit générateur de courant continu est piloté par un capteur de courant à effet Hall ayant un tore à entrefer et un enroulement primaire constitué par le conducteur dudit réseau.

La composante alternative, représentative d'un défaut d'isolement, est mesurée par le transformateur de courant dont la polarisation par le courant continu est quasiment annulée par le courant circulant dans l'enroulement de compensation. Tout risque de saturation du matériau magnétique est ainsi exclu et la mesure est suffisamment précise pour assurer une détection fiable.

L'enroulement de compensation comporte un grand nombre de spires et un faible courant de compensation équilibre ainsi l'action du courant continu du réseau.

La composante continue du courant du réseau est mesurée par le capteur à effet Hall, dont l'entrefer évite une saturation du matériau du tore. La précision de ces capteurs est de l'ordre de 1% et la compensation est donc réalisée avec une précision du même ordre de grandeur, c'est à dire qu'il subsiste un courant continu résiduel dans le transformateur de mesure d'environ 1,5A dans le cas d'un courant continu nominal de environ 150A du réseau.

En choisissant selon l'invention pour le matériau magnétique du tore de mesure, un matériau ayant un cycle d'hystérésis dit couché, l'influence de cette composante continue résiduelle peut, d'une manière bien connue des spécialistes, être réduite. Le signal de mesure émis par le transformateur de courant est amplifié dans un bloc de traitement qui comporte un filtre de coupure des fréquences hautes pour améliorer la détection. L'emploi d'un filtre accordé sur la fréquence de mesure assure une amplification par résonance. La fréquence du courant alternatif injectée dans le réseau est, selon un développement de l'invention voisine de 10HZ, mais d'autres fréquences sont utilisables. Des dispositifs de contrôle selon l'invention peuvent être disposés en différents points du réseau pour localiser plus facilement le défaut.

Le système de compensation selon l'invention convient parfaitement à des réseaux à courant continu dont l'intensité ne dépasse pas 160A. Pour des intensités supérieures une saturation du tore de mesure par le courant continu résiduel n'est pas exclue, et la fiabilité de la détection est remise en cause. Le dispositif selon l'invention peut être adapté à des courants continus plus importants, allant jusqu'à 1000A, en utilisant deux capteurs à effet Hall de calibres différents. Ces deux capteurs sont disposés en cascade, afin de réaliser une première compensation grossière avec le premier, grâce à un enroulement de compensation porté par le deuxième capteur à effet Hall et une compensation plus fine par le deuxième.

D'autres avantages et caractéristiques ressortiront plus clairement de la description qui va suivre d'un mode de mise en oeuvre de l'invention, donné à titre d'exemple non limitatif et représenté au dessin annexé dans lequel:
La figure 1 montre le schéma d'un dispositif de contrôle d'isolement selon l'invention;
La figure 2 est une vue analogue à celle de la figure 1 illustrant une variante de réalisation.

Sur les figures un réseau simplifié 10, isolé de la terre 12, comporte deux conducteurs 14,16 de liaison d'une charge 18, schématiquement représentée par une résistance, à une source 20 de courant continu. Le réseau 10 peut être celui d'un bateau, dont la source de courant 20 est une génératrice et la charge 18, toute l'installation électrique. La terre 12 est constituée par la structure métallique et la coque du bateau. L'invention est bien entendu applicable à tout autre réseau à courant continu, par exemple d'alimentation, de moteurs ou de groupes d'électrolyse, ce réseau étant généralement plus complèxe, notamment en antenne, en boucle ou mixte d'une manière bien connue des spécialistes.

Un générateur de courant alternatif 22 est relié d'une part au conducteur 14 et d'autre part à la terre 12 pour injecter un courant alternatif, par exemple d'une fréquence de 10HZ, dans le réseau 10. En l'absence de défaut à la terre aucun courant alternatif ne circule dans les conducteurs 14,16, lesquels alimentent normalement la charge 18 en courant continue. Lors d'un premier défaut à la terre, par exemple à l'emplacement 24, l'alimentation de la charge 18 n'est pas perturbée, une interruption n'intervenant que si un deuxième défaut à la terre apparaît, par exemple en 26. L'apparition du premier défaut à la terre crée néanmoins une situation dangereuse qui doit être détectée afin d'y rémédier le plus rapidement possible.

Cette détection d'un premier défaut à la terre est réalisée par un détecteur 27 de défaut d'isolement associé au conducteur 14. Le détecteur 27 comporte un capteur de courant à effet Hall 28 et un transformateur de courant 38. Le capteur de courant 28 est constitué par un tore 30 ayant un entrefer 32 dans lequel est disposé une cellule Hall 34. Le conducteur 14 traverse le tore 30 à entrefer, dont il constitue l'enroulement primaire, de manière à engendrer un champ magnétique dans le tore 30 à entrefer proportionnel au courant parcourant le conducteur 14. L'intensité de ce champ est mesurée par la cellule Hall 34 qui délivre un signal correspondant. Le conducteur 14 traverse de plus un tore de mesure 36 du transformateur de courant 38, qui porte deux enroulements secondaires, un enroulement de mesure 40 et un enroulement de compensation 42. Le tore de mesure 36 est en un matériau magnétique dépourvu d'entrefer et ayant un cycle d'hystérésis couché à bonne perméabilité incrémentale pour un champ continu correspondant à un courant continu résiduel d'environ 1/100ème du courant nominal du réseau. L'enroulement de mesure 40 est relié à un bloc de traitement et de mesure 44 tandis que l'enroulement de compensation 42 est relié à un générateur de courant continu 46 ayant une entrée de commande 48 reliée à la cellule Hall 34 par un bloc amplificateur 50.

Le dispositif de contrôle fonctionne de la manière suivante:

En l'absence de défaut à la terre, seul un courant continu circule dans le réseau, notamment dans les conducteurs 14,16. Ce courant est détecté par le tore 30 à entrefer et la cellule Hall 34 pilote le générateur 46 afin que le courant fourni à l'enroulement de compensation 42 engendre dans le tore de mesure 36 un champ magnétique opposé à celui engendré par le courant dans le conducteur 14.

Aucun courant n'est induit dans l'enroulement de mesure 40, car un éventuel champ magnétique résiduel, dû à l'imprécision de la mesure du courant continu et de la chaîne de compensation, est un champ continu de polarisation du tore de mesure 30. Cette polarisation est suffisamment faible pour éviter toute saturation. En utilisant un matériau magnétique à cycle couché, l'influence de la composante continue peut être réduite.

Lors d'un défaut 24 à la terre, le circuit de courant continu n'est pas perturbé, mais le circuit alternatif se referme par la terre 12 et un courant alternatif venant du générateur 22 parcourt le conducteur 14, le défaut 24 pour revenir par la terre 12 au générateur 22. Ce courant est faible, par exemple de 3 à 20 mA et n'est pas dangereux si le défaut à la terre est provoqué par une personne. Ce courant est négligeable par rapport au courant continu, par exemple de 150A, parcourant le conducteur 14 et par rapport à la précision de mesure du capteur à effet Hall 28. Le signal émis par ce capteur 28 peut éventuellement être filtré pour éliminer les fluctuations dues au courant alternatif et transmettre au générateur de courant continu 46 un signal proportionnel au courant continu dans le conducteur 14. Ce générateur 46 excite l'enroulement de compensation 42 pour compenser de la manière décrite ci-dessus l'action du courant continu dans le conducteur 14. Le transformateur de courant 38 n'est que faiblement polarisé par le courant résiduel dû à l'imprécision de la compensation et le courant alternatif parcourant le conducteur 14 engendre un champ magnétique dans le tore de mesure 36 qui induit un courant dans l'enroulement de mesure 40 représentatif du courant alternatif. Le signal émis par le transformateur de courant 38 est transmis au bloc de traitement et de mesure 44, qui signale le défaut à la terre d'un manière appropriée. Le traitement du signal peut comporter une amplification, notamment par un circuit résonant, et/ou un filtrage de coupure des fréquences hautes. La détection est fiable et suffisamment précise tant que l'intensité du courant continu du réseau reste comprise entre 10 et 300 Ampères. L'intensité du courant alternatif injecté est comprise entre 1 et 100 milliampères et de préférence entre 3 et 20 milliampères.

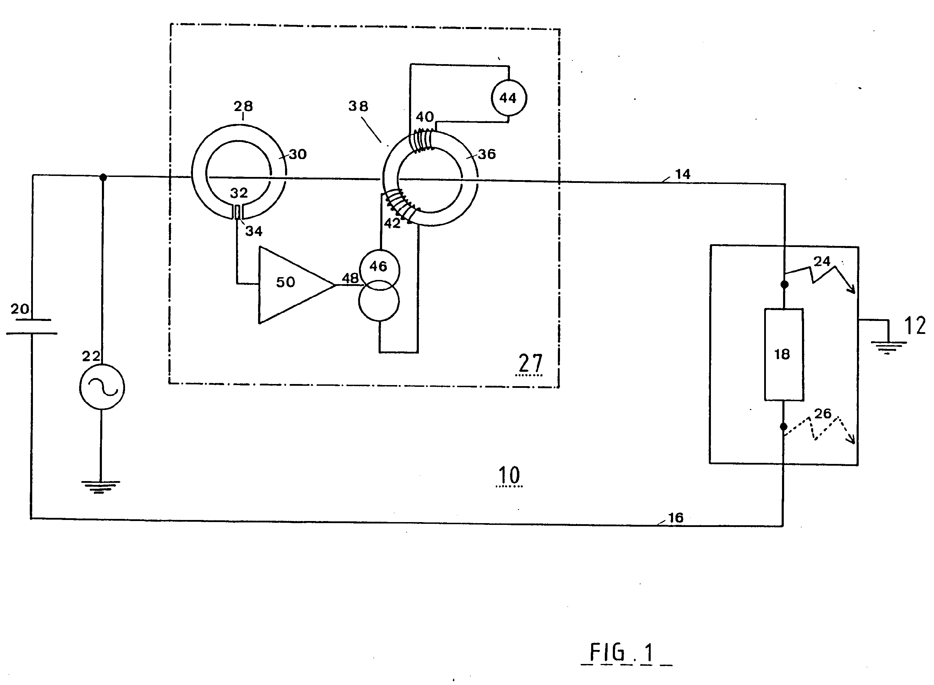

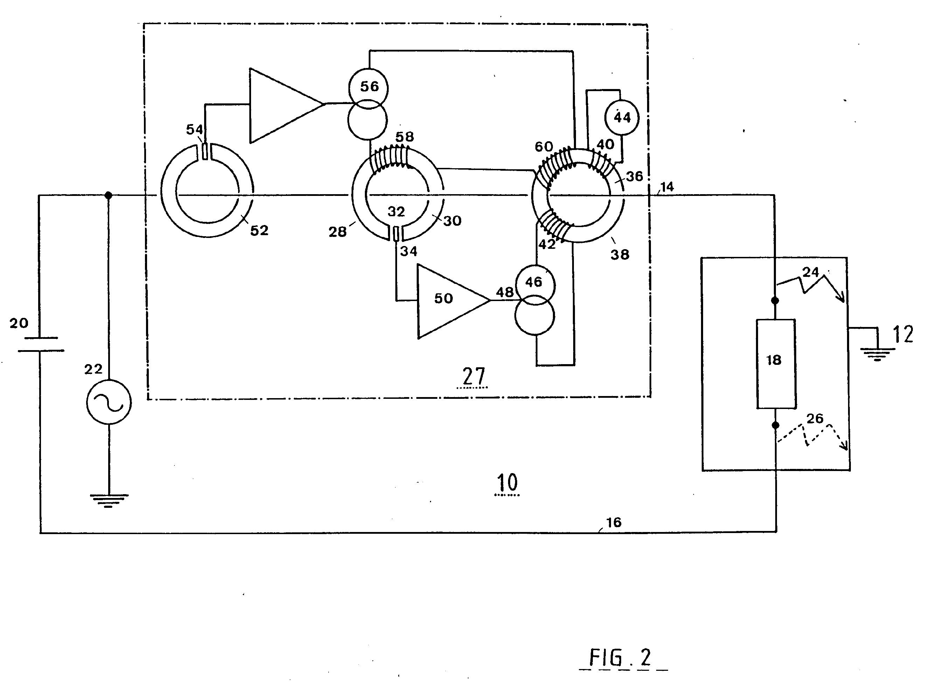

La figure 2 illustre une variante de réalisation particulièrement appropriée à des réseaux plus importants, par exemple d'une intensité allant jusqu'à 1000 ampères. Les mêmes numéros de référence sont utilisés pour désigner des éléments analogues ou identiques à ceux de la figure 1. La détection de défaut comporte un deuxième capteur à effet Hall 52 d'un calibre nettement plus élevé de celui du capteur à effet Hall 28. La cellule Hall 54 de ce deuxième capteur 52 pilote de la manière décrite ci-dessus un générateur de courant continu 56, qui alimente deux enroulements de compensation, l'un 58 porté par le tore 30 à entrefer et l'autre 60 porté par le tore de mesure 36, de manière à compenser approximativement dans le tore 30 à entrefer et dans le tore de mesure 36 l'action du courant continu du conducteur 14. Cette compensation est réalisée avec une certaine imprécision, par exemple de 1% et le courant résiduel non compensé agissant sur le tore 30 à entrefer est alors au maximum de 100 ampères. Ce courant résiduel est mesuré par la cellule Hall 34, qui provoque une compensation plus fine de la manière précitée. Le fonctionnement est identique à celui décrit en relation à la figure 1, mais la compensation est réalisée en deux étapes successives. Il est clair que le nombre d'étapes peut être multiplié pour des courants de plus forte intensité. Les valeurs indiquées correspondent aux caractéristiques des composants actuels et doivent être adaptées aux améliorations éventuelles des précisions de mesure.

## Revendications

1. Dispositif de contrôle d'isolement d'un réseau à courant continu en service et isolé de la terre, ayant un générateur de courant alternatif (22) connecté entre la terre (12) et le réseau pour injecter un courant alternatif dans le réseau sous une tension non dangereuse pour les personnes et un transformateur de courant (38) ayant un tore de mesure (36) portant un enroulement primaire constitué par le conducteur (14) dudit réseau et un enroulement secondaire de mesure (40), caractérisé en ce que ledit tore de mesure (36) comporte de plus un enroulement de compensation (42) alimenté par un générateur de courant continu (46) de façon à engendrer dans le tore de mesure (36) un champ magnétique antagoniste au champ engendré par le courant continu et que ledit générateur de courant continu (46) est piloté par un capteur de courant (28) à effet Hall ayant un tore à entrefer (30) et un enroulement primaire constitué par le conducteur (14) dudit réseau.

2. Dispositif de contrôle selon la revendication 1, caractérisé en ce que l'enroulement de compensation (42) comporte un nombre de spires multiple du nombre de spires de l'enroulement primaire (14) de façon à compenser l'action dudit courant continu parcourant l'enroulement primaire par l'action d'une fraction de courant parcourant l'enroulement de compensation.

3. Dispositif de contrôle selon la revendication 1 ou 2, caractérisé en ce que le matériau magnétique dudit tore de mesure (36) est un matériau ayant un cycle d'hystérésis couché ayant une bonne perméabilité incrémentable pour un champ continu correspondant à un courant continu résiduel d'environ 1/100ème du courant nominal du réseau.

4. Dispositif de contrôle selon la revendication 1,2 ou 3, caractérisé en ce que la fréquence dudit courant alternatif est voisine de 10HZ.

5. Dispositif de contrôle selon l'une quelconque des revendications précédentes, caractérisé en ce que ledit tore (30) à entrefer (32) du capteur à effet Hall porte un enroulement primaire constitué par le conducteur (14) dudit réseau et une cellule Hall (34) disposée dans ledit entrefer (32).

6. Dispositif de contrôle selon l'une quelconque des revendications précédentes, caractérisé en ce que l'intensité du courant continu est comprise entre 10 et 300 ampères et que l'intensité du courant alternatif injecté est comprise entre 1 et 100mA.

7. Dispositif de contrôle selon l'une quelconque des revendications 1 à 5 pour des courants continus de forte intensité, caractérisé en ce que le tore (30) à entrefer du capteur à effet Hall (28) porte un enroulement de compensation (58) et que le tore de mesure (36) porte un deuxième enroulement de compensation (60) connecté en série avec l'enroulement de compensation (58) du tore (30) à entrefer pour être alimentés tous deux par un deuxième générateur de courant continu (56) piloté par un deuxième capteur à effet Hall (52) dont l'enroulement primaire est constitué par le conducteur (14) dudit réseau.

## Patentansprüche

1. Vorrichtung zur Kontrolle der Isolierung eines in Betrieb befindlichen nicht geerdeten Gleichstromnetzes bestehend aus einem zwischen der Erdung (12) und dem Stromnetz geschalteten Wechselstromgenerator (22), der unter einer für den Menschen ungefährlichen Spannung einen Wechselstrom in das Netz einspeist und einem Stromwandler (38) mit einem Meßkern (36) bestehend aus einer Primärwicklung, die sich aus dem Leiter (14) des besagten Netzes zusammensetzt, sowie einer sekundären Meßwicklung (40), dadurch gekennzeichnet, daß der besagte Meßkern (36) ferner über eine Kompensationswicklung (42) verfügt, die durch einen Gleichstromgenerator (46) so eingespeist wird, daß im Meßkern (36) ein zu dem durch den Gleichstrom erzeugten Magnetfeld entgegenwirkendes magnetisches Feld entsteht und dadurch, daß der besagte Gleichstromgenerator (46) von einem Strommeßfühler (28) mit Hall-Effekt gesteuert wird, wobei dieser über einen Kern mit Luftspalt (30) und eine aus dem Leiter (14) des besagten Netzes bestehende Primärwicklung verfügt.

2. Vorrichtung zur Kontrolle nach Anspruch 1, dadurch gekennzeichnet, daß die Kompensationswicklung (42) über eine Anzahl von Windungen verfügt, die ein Vielfaches der Windungen der Primärwicklung (14) darstellt, wobei hiermit die Wirkung des besagten in der Primärwicklung fließenden Gleichstromes durch den Einfluß eines Bruchteils des in der Kompensationswicklung fließenden Stroms kompensiert wird.

3. Vorrichtung zur Kontrolle nach Anspruch 1 oder 2, dadurch gekennzeichnet, daß es sich bei dem Magnetwerkstoff des besagten Meßkerns (36) um einen Werkstoff mit einer geneigten Hysterisisschleife mit guter inkrementaler Permeabilität handelt bei einem Gleichfeld, das einem Restgleichstrom von ungefähr 1/100 des Nennstromes des Netzes entspricht.

4. Vorrichtung zur Kontrolle nach Anspruch 1, 2 oder 3, dadurch gekennzeichnet, daß die Frequenz des besagten Wechselstromes bei 10 Hz liegt.

5. Vorrichtung zur Kontrolle nach irgendeinem der obengenannten Ansprüche, dadurch gekennzeichnet, daß der besagte Kern (30) mit Luftspalt (32) des Meßfühlers mit Hall-Effekt über eine aus dem Leiter (14) des besagten Netzes und einer in dem besagten Luftspalt (32) angeordneten Hall-Sonde bestehenden Primärwicklung verfügt.

6. Vorrichtung zur Kontrolle nach irgendeiner der obengenannten Ansprüche, dadurch gekennzeichnet, daß die Stromstärke des Gleichstromes zwischen 10 und 300A liegt sowie dadurch, daß die Stromstärke des eingespeisten Wechselstromes zwischen 1 und 100 mA liegt.

7. Vorrichtung zur Kontrolle nach einem der obengenannten Ansprüche 1 bis 5 für Gleichströme hoher Stromstärke, dadurch gekenzeichnet, daß der Kern (30) mit Luftspalt des Meßfühlers mit Hall-Effekt (28) über eine Kompensationswicklung (58) verfügt und dadurch, daß der Meßkern (36) über eine zweite Kompensationswicklung (60) verfügt, die mit der Kompensationswicklung (58) des Kerns (30) mit Luftspalt in Reihe geschaltet ist, wobei alle beide von einem zweiten Gleichstromgenerator (56) eingespeist werden, der wiederum von einem zweiten Meßfühler mit Hall-Effekt (52) gesteuert wird, wobei dessen Primärwicklung aus dem Leiter (14) des besagten Netzes besteht.

## Claims

1. An insulation monitoring device of a direct current power supply system, in operation and insulated from the ground, with an alternating current generator (22) connected between the ground (12) and the supply system to apply an alternating current to the supply system at a voltage that is not dangerous for people, and a current transformer (38) having a measuring toroid (36) bearing a primary winding constituted by the conductor (14) of said supply system and a secondary measurement winding (40), characterized in that said measuring toroid (36) comprises further a compensation winding (42), supplied by a direct current generator (46) in order to generate in the measuring toroid (36) a magnetic field opposing the field generated by the direct current, and that said direct current generator (46) is controlled by a Hall-effect current sensor (28) having an air-gap toroid (30) and a primary winding constituted by the conductor (14) of said supply system.

2. The monitoring device according to claim 1, characterized in that the compensation winding (42) comprises a number of turns which is a multiple of the number of turns of the primary winding (14) so as to counterbalance the action of said direct current flowing in the primary winding by the action of a fraction of the current flowing in the compensation winding.

3. The monitoring device according to claim 1 or 2, characterized in that the magnetic material of said measuring toroid (36) is a material having a flat hysteresis cycle having a good incrementable permeability for a direct field corresponding to a residual direct current of about 1/100th of the rated supply system current.

4. The monitoring device according to claim 1, 2 or 3, characterized in that the frequency of said alternating current is close to 10 HZ.

5. The monitoring device according to one of the preceding claims, characterized in that the Hall-effect sensor comprises a toroid (30) with an air-gap (32) bearing a primary winding constituted by the conductor (14) of said supply system and a Hall-cell (34) arranged in said air-gap (32).

6. The monitoring device according to anyone of the preceding claims, characterized in that the intensity of the direct current is comprised between 10 and 300 Amps and that the intensity of the alternating current applied is comprised between 1 and 100mA.

7. The monitoring device according to anyone of the claims 1 to 5, for high-intensity direct currents, characterized in that the air-gap toroid (30) of the Hall-effect sensor (28) bears a compensation winding (58) and that the measuring toroid (36) bears a second compensation winding (60) connected in series with the compensation winding (58) of the air-gap toroid (30) in order to be both supplied by a second direct current generator (56) controlled by a second Hall-effect sensor (52) whose primary winding is constituted by the conductor (14) of said supply system.
